(19) Europäisches Patentamt
European Patent Office
Office européen des brevets

(11) EP 1 729 489 A1

(12) **EUROPEAN PATENT APPLICATION**

(43) Date of publication:
**06.12.2006 Bulletin 2006/49**

(51) Int Cl.:
***H04M 3/30*** *(2006.01)* ***G01R 27/26*** *(2006.01)*

(21) Application number: **05011706.8**

(22) Date of filing: **31.05.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicants:
- **Infineon Technologies AG**
  **81669 München (DE)**
- **Marconi Communications Limited**
  **Coventry, CV3 1HJ (GB)**

(72) Inventors:
- **Blechschmidt, Klaus**
  **85304 Ilmmünster (DE)**
- **Linder, Thomas**
  **9800 Spittal (AT)**
- **Schönberger, Michael**
  **85586 Poing (DE)**
- **Wippich, Günter**
  **85570 Markt Schwaben (DE)**
- **Springett, Chris**
  **CV3 5JA Coventry (GB)**

(74) Representative: **Bertsch, Florian Oliver et al**
**Kraus & Weisert,**
**Thomas-Wimmer-Ring 15**
**80539 München (DE)**

# (54) Method of measuring a capacitive property of a communication line and corresponding apparatus

(57) For determining at least one capacitive property (Ctg,Crg,Ctr) of a communication line comprising a first line (6) and a second line (7), e.g. in a POTS communication system, it is proposed that at least a first voltage ramp is applied to the communication line and the current flowing through the communication line during the first voltage ramp is measured. Preferably, a sequence of a first voltage ramp and a second voltage ramp is applied to the communication line, the second voltage ramp being inverted with respect to the first voltage ramp, and the currents flowing through the communication line during the first voltage ramp and during the second voltage ramp are integrated and subtracted. By this means, effects of resistive properties (Rtg,Rrg,Rtr) of the communication line on the measurement of the capacitive properties (Ctg,Crg,Ctr) can be eliminated in the measurement process. In order to determine a plurality of capacitive properties, a plurality of measurements may be performed each, using a different configuration of the communication line. The different configurations may be obtained by switching either the first line (6) or the second line (7) into an essentially disconnected state.

FIG 1

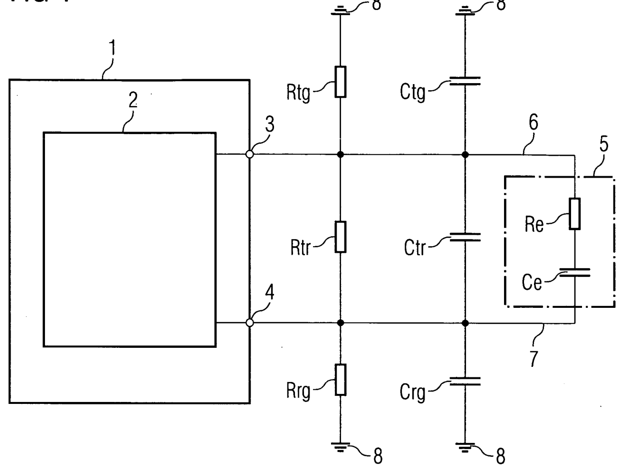


EP 1 729 489 A1

## Description

Method of measuring a capacitive property of a communication line and corresponding apparatus

The present invention relates to a method of measuring at least one capacitive property of a communication line and to a corresponding apparatus. In particular, the invention relates to measuring capacitances in an equivalent circuit of a communication line comprising a tip line and a ring line, such as in a communication line of a POTS (Plain Old Telephone Service) communication system.

In POTS or other communication systems it is advisable to perform a regular testing of communication lines, for example communication lines running from a central office terminal to end users ("subscribers"), so-called subscriber lines. With such a regular line testing, deteriations or faults of the communication lines can be detected quickly and corresponding measures can be taken. In such a line testing operation, typically electrical properties of the communication line such as resistances and capacitances are of interest.

In Fig. 16, a conventional setup for line testing is shown. A linecard 38 has a plurality of POTS circuits 39, i.e. respective POTS chip sets for driving a plurality of two-wire communication lines, each two-wire communication line comprising a tip line 41 and a ring line 42. A backplane connection 49 serves to connect the POTS circuits 39 to further circuitry for data processing.

Associated with each of the POTS circuits 39 is a test relay 40 which serves to selectively connect one pair of tip line 41 and ring line 42 to a test bus 43. The test bus 43 typically has connections to a test board 44 comprising analogue circuitry 45, a digital signal processor 46, a random access memory (RAM) 47 and a read-only memory (ROM) 48. The components on the test board 44 serve to perform various tests like resistance measurements on the communication lines which are selectively connected to the test bus 43 via the respective test relay 40.

This solution needs a test relay 40 for each POTS circuit 39, i.e. for each subscriber line, and a separate test board 44. With the test board 44, which is normally present only once in a given system, only one communication line can be tested simultaneously.

Instead of an internal test board, also an external test head with essentially the same functionalities may be used.

An alternative approach is shown in Fig. 17. Here, a linecard 51 comprises a plurality of combined POTS circuits/digital signal processors (DSP) 50, each driving a subscriber line comprising a tip line 41 and a ring line 42. Again, the POTS circuits are connected via a backplane connection 49 to further circuitry. In this case, the test functions are integrated in the POTS circuits, for example in a subscriber line interface circuit (SLIC) or in a coder/decoder (CODEC). In known linecards of this type, only limited measurements can be performed on the subscriber lines since, for instance, an independent grounding of either the tip line 41 or the ring line 42 is not possible without additional circuitry, and therefore additional chip area is needed, causing additional costs. The typical method used to determine electrical properties of a communication line is based on applying a given voltage to the communication line and measuring the resulting current. With this method, only an overall resistance of the subscriber line can be measured. More detailed information, e.g. specific resistances or capacitances in the equivalent circuit of the communication line cannot be obtained.

In view of the above, it is an object of the present invention to provide a method of measuring at least one capacitive property of a communication line and a corresponding apparatus, by means of which the capacitive property and also other electrical properties of the communication line can be obtained in a precise manner and with little outlay.

This object is achieved by a method according to claim 1 and by an apparatus according to claim 20. The dependent claims define advantages or preferred embodiments of the invention.

The invention provides a method of measuring at least one capacitive property of a communication line which comprises at least a first line and a second line. For example, the communication line may be a two-wire subscriber line in a POTS communication system. In order to determine the at least one capacitive property, at least a first voltage ramp is applied to at least one of the first line and the second line, and a first current flowing via the at least one of the first line and the second line is measured during the first voltage ramp. The capacitive property is then calculated on the basis of the first measured current. Consequently, the invention takes advantage of the fact that when a changing voltage is applied to a capacitor, the current flowing into or from the capacitor is proportional to the rate of voltage change, i.e. the derivative of the voltage as a function of time. By applying a voltage ramp, in which the rate of voltage change has a well-defined magnitude, it is therefore possible to accurately determine a capacitance of the circuit to which the voltage ramp is applied.

In general, also resistances are present in the equivalent circuit of the communication line. According to a preferred embodiment of the invention, resistive properties of the communication line are taken into account by further applying a second voltage ramp to the at least one of the first line and the second line and measuring a second current flowing via the at least one of the first line and the second line during the second voltage ramp. The second voltage ramp is generated in such a manner that it is inverted with respect to the first voltage ramp, i.e. the first voltage ramp and the second voltage ramp preferably have slopes of equal magnitude and of opposite sign, a start voltage of the second voltage ramp corresponds to an end voltage of the first voltage ramp, and an end voltage of the second voltage ramp corresponds to a start voltage of the first voltage ramp. With such a symmetrical configuration of the first voltage ramp and the second voltage ramp, the capacitive property of the communication line can be calculated in an particularly advantageous way by substantially taking the difference of the first measured current and the second measured current. Generally, the measured current will be composed of a current due to the resistive properties of the communication line and a current due to the capacitive properties of the communication line. The current due to the resistive properties depends on the actual value of the voltage applied to the communication line, whereas the current due to the capacitive property depends, as explained above, on the rate of the voltage change. Therefore, the currents due to the resistive properties cancel out in the difference of the first measured current and the second measured current and the currents due to the capacitive properties are doubled. Consequently, it is possible to accurately determine the capacitive property without any adverse influence on the measurement process from resistive properties of the communication line.

In addition, it is preferable to integrate the first measured current and the second measured current and to subtract the integrated first measured current and the integrated second measured current. The integration is preferably performed over the duration of the first voltage ramp and the second voltage ramp. It may, however, also be possible to select other appropriate integration windows. By means of the integration, an improved accuracy is achieved and transient effects are eliminated from the result.

Further, it is preferred that additional measurements are performed so as to take into account in a more detailed way the resistive properties of the communication line. This may in particular involve applying a voltage to at least one of the first line and the second line, to measure the current flowing via the at least one of the first line and the second line, and/or to measure a voltage present at the first line and/or the second line. In such measurements results are obtained which reflect the resistive properties of the communication line. These results may on the one hand be used for a more detailed determination of the capacitive properties of the communication line, i.e. to determine parameters of a more detailed equivalent circuit of the communication line. On the other hand, these results may be used to determine resistive parameters of the equivalent circuit.

In order to determine a plurality of parameters of the equivalent circuit, i.e. to determine a plurality of capacitive properties or a plurality of resistive properties, it is preferable to perform a plurality of measurements in different configurations of the communication line. The different configurations preferably correspond to switching a first line driver connected to the first line or a second line driver connected to the second line into either a high-impedance state or into a low-impedance state, the latter corresponding to the normal configuration of the line driver. In a configuration in which one of the first line and the second line in an essentially disconnected state by switching the line driver into the high-impedance state it is possible to obtain measurement results which reflect the coupling of the communication line with respect to ground. The above-mentioned procedures of applying a voltage ramp or a voltage and measuring the current or the voltage can be performed in each of the different configurations. The results from the plurality of measurements can then be combined to determine the different parameters of the equivalent circuit of the communication line. This may, for example, involve solving a linear equation system into which the measurement results are entered.

In case that the communication line essentially corresponds to a two-wire subscriber line of a POTS communication system, the first line and the second line of the communication line correspond to a tip line and a ring line. The equivalent circuit of the communication line may comprise a capacitance between the first line and the second line, a capacitance between the first line and ground, a capacitance between the second line and ground, a resistance between the first line and the second line, a resistance between the first line and ground, and a resistance between the second line and ground.

The functionalities needed for performing the method of the present invention are present in some POTS chip sets or may be easily implemented therein, so that no additional circuitry is needed. In particular, a voltage ramp generator for applying the voltage ramp to the communication line may be implemented by a suitably configured ring voltage generator. Further, the first line driver and the second line driver which are used for obtaining the different configurations of the communication line may be included in a subscriber line interface circuit (SLIC) whereas for performing the current measurements and voltage measurements corresponding functionalities of a coder/decoder (CODEC) may be used.

The apparatus according to the present invention for measuring at least one capacitive property of the communication line comprises a control unit for controlling the process of measuring the at least one capacitive property, a voltage ramp generator, current measuring means and calculating means. As mentioned above, these functionalities are preferably integrated in a POTS chip set or a linecard to be connected to the communication line. The apparatus is preferably configured to implement the above-described method according to the present invention.

Next, a preferred embodiment of the present invention will be described in detail with reference to the accompanying drawings.

Fig. 1 shows an equivalent circuit of a communication line to be tested,

Fig. 2 shows a schematic circuit diagram of an embodiment of the present invention,

Fig. 3 shows a flow chart for performing a first set of measurements for measuring resistive properties of the communication line of Fig. 1,

Fig. 4 shows an equivalent circuit of a configuration in which a second set of measurements for measuring the resistive properties is performed,

Fig. 5 shows a flowchart for performing the second set of measurements for measuring the resistive properties,

Fig. 6 shows an equivalent circuit of a configuration for performing a third set of measurements for measuring the resistive properties,

Fig. 7 shows a flowchart for performing the third set of measurements for measuring the resistive properties,

Fig. 8 shows a flowchart for calculation of a resistance between one line of the communication line and ground when a resistance between the two lines of the communication line is high,

Fig. 9 shows an equivalent circuit of a configuration for performing a first set of measurements for measuring capacitive properties of the communication line of Fig. 1,

Fig. 10 illustrates a sequence of two voltage ramps applied to the communication line and the current measured during the voltage ramps,

Fig. 11 shows a flowchart for performing the first set of measurements for measuring the capacitive properties,

Fig. 12 shows an equivalent circuit of a configuration for performing a second set of measurements for measuring the capacitive properties,

Fig. 13 shows a flowchart for performing the second set of measurements for measuring the capacitive properties,

Fig. 14 shows an equivalent circuit of a configuration for performing a third set of measurements for measuring the capacitive properties,

Fig. 15 shows a flowchart for performing the third set of measurements for measuring the capacitive properties,

Fig. 16 shows a conventional apparatus for line testing, and

Fig. 17 shows another conventional apparatus for line testing.

Fig. 1 shows an equivalent circuit of a communication line to be measured or tested together with a schematic representation of an apparatus according to the present invention.

A linecard 1 comprises a Plain Old Telephone Service (POTS) chipset 2 which on the one hand is used for communication purposes and on the other hand is used for performing measurements of electrical properties of a communication line. In the present case, the communication line consists of a tip line 6 connected to a tip connector 3 and a ring line 7 connected to a ring connector 4 of the linecard 1. Electrical properties of the communication line include a resistance Rtr between tip line 6 and ring line 7, a resistance Rtg between tip line 6 and ground 8, a resistance Rrg between ring line 7 and ground 8, a capacitance Ctr between tip line 6 and ring line 7, a capacitance Ctg between tip line 6 and ground 8 and a capacitance Crg between ring line 7 and ground 8. Furthermore, in a connected state, at a far end of the communication line a subscriber device 5 is present, represented by a resistance Re and a capacitance Ce connected in series. The resistances Rtg, Rrg and Rtr are basically leak resistances which, in a fault-free state of the communication line, should be high. The capacitances Ctg, Crg and Ctr are basically parasitic capacitances which, in a fault-free state of the communication line, should be low. Measuring these resistances and capacitances can give valuable information with respect to possible faults.

It should be noted that, generally, the linecard 1 may comprise a plurality of POTS circuits or chipsets 2 connected to a plurality of subscriber lines, each subscriber line including a tip line and a ring line. For simplification, only one such POTS circuit is represented.

In Fig. 2, the POTS chipset 2 and the connections thereof are represented in greater detail. The POTS chipset 2 primarily comprises a subscriber line interface circuit (SLIC) 9 and a further POTS integrated circuit, chip or chipset 10 which, for example, may provide coder/decoder (CODEC) or further signal processing functionalities. SLIC 9 and integrated circuit 10 together form the POTS chipset and work together in normal communication mode. Therefore, additional connections between SLIC 9 and integrated circuit 10 and also a backplane connection with further parts of the communication device are present which are not shown in Fig. 2 since they are not essential for performing the measurements according to the present invention.

SLIC 9 comprises a first line driver 9A and a second line driver 9B, the first line driver 9A being connected via resistors R1 and R3 to tip connector 3 for driving the tip line 6 of Fig. 1, and the second line driver 9B being connected via resistors R2 and R4 with ring connector 4 for driving the ring line 7. Additionally, in this connection, capacitors C1 and C2 are connected to ground 8 as shown in Fig. 2. Typical resistor values are 30 Ω for R1 and R2 and 20 Ω for R3 and R4. The resistors R1, R2, R3, R4 and the capacitances C1 and C2 have known values and thus can easily be taken into account when evaluating the electrical properties of the communication line.

The first line driver 9A and the second line driver 9B may be activated or deactivated; in a deactivated state they have a high impedance meaning that no or little leakage current may flow via the respective line driver. Typical values are leakage currents smaller than +/- 30 $\mu$A for voltages up to 150 V, however, the leakage current in the deactivated or high-impedance state may be as high as 150 $\mu$A corresponding to a resistance of the order of 1 MΩ.

The SLIC 9 further has the capability of measuring a current flowing into or from tip connector 3 and ring connector 4. Such a functionality is usually provided in commercially available SLICs since it is also needed in normal communication.

The integrated circuit 10 is a circuit which has the capability of measuring voltages present on the tip connector 3 and the ring connector 4. This capability usually is also present in some chips in commercially available POTS chipsets, e.g. for measuring a battery voltage. According to the present invention, this functionality is used for line testing purposes.

Integrated circuit 10 is connected to tip connector 3 and ring connector 4 via respective voltage measuring lines.

Integrated circuit 10 comprises a built-in measurement control 10A or control unit which controls the measurements performed according to the present invention by SLIC 9 and integrated circuit 10. However, the control of the measurements which is usually realized by software may also be realized in SLIC 9 or in some other (not shown) part of the chipset which is also responsible for controlling the operation of SLIC 9 and integrated circuit 10 during normal communication operation. Further, integrated circuit 10 comprises a voltage ramp generator 11 for generating voltage ramps to be applied to the tip connector 3 and/or the ring connector 4. The voltage ramp generator 11 is implemented as a suitably designed ring voltage generator. In particular, the voltage ramp generator 11 is configured in such a manner that it can generate with a high accuracy voltage ramps which are inverted with respect to each other. This means that the slopes of the voltage ramps have exactly the same magnitude but opposite signs and that the start voltage of the second voltage ramp exactly corresponds to the end voltage of the first voltage ramp and that the end voltage of the second voltage ramp exactly corresponds to the start voltage of the first voltage ramp.

In the following, it will be explained how the electrical properties of the communication line, i.e. the resistances Rtg, Rrg and Rtr and the capacitances Ctg, Crg and Ctr can be measured using the POTS circuitry as explained above. For this purpose, first the measurement of the resistances will be explained. For the measurement of the resistances, the capacitances may be neglected. The values obtained for the resistances may, however, be used when evaluating the capacitances. It is therefore preferred to first evaluate the resistances and then to evaluate the capacitances. Of course, it would also be possible to perform the necessary sets of measurement and then to evaluate the resistances and the capacitances simultaneously. It should also be noted it is possible that capacitive properties can be determined without having to determine the resistive properties of the communication line.

Measurement of the resistive properties, i.e. the resistances Rtg, Rrg, Rtr will in the following be explained with reference to Figs. 3-8.

To determine the resistances Rtg, Rrg and Rtr, three distinctive sets of measurements are performed with different configurations of the communication line. Fig. 3 shows a flow chart of the first set of measurements. During this first set of measurements, both line drivers 9A and 9B are active and may be used to apply a voltage to the tip line and the ring line, respectively. Therefore, for the first set of measurements a first configuration is used, in which both line drivers 9A, 9B are in the activated or low-impedance state.

In step 12 of Fig. 3, the first set of measurements is started. In step 13, a so-called transversal voltage is applied to the communication line consisting of tip line 6 and ring line 7, i.e. a voltage between tip line 6 and ring line 7 corresponding to a differential voltage being applied at tip connector 3 and tip connector 4. This is done by using the first line driver 9A and the second line driver 9B such that a voltage applied by first line driver 9A is greater than a voltage applied by second line driver 9B.

Next, in step 14, a voltage Vt1 at tip connector 3 and a voltage Vr1 at ring connector 4 are measured using integrated circuit 10, and a voltage difference ΔV1 is calculated by measurement control 10A according to ΔV1 = Vt1-Vr1. This and the following calculations may, however, be performed in any suitable computing logic provided on linecard 1.

In step 15, a current It1 flowing between tip connector 3 and ring connector 4 is measured by SLIC 9. Of course, steps 14 and 15 may be performed simultaneously or in reverse order.

In step 16, a transversal voltage having the opposite sign as the transversal voltage applied in step 13 is applied to the subscriber line, i.e. the voltage applied by first line driver 9A is now smaller than the voltage applied by second line driver 9B. The magnitude of the transversal voltage applied in step 13 and the transversal voltage applied in step 16 may be of the same or approximately of the same magnitude.

In step 17, the voltage at tip connector 3 Vt2 and the voltage at ring connector 4 Vr2 are measured, and their difference $\Delta V2 = Vt2-Vr2$ is calculated, similar to the measurements and calculations performed in step 14. In step 18, the corresponding current It2 is measured similar to the current It1 measured in step 15.

Finally, in step 19, a resistance Ra, also called "active resistance", is calculated according to

$$Ra = \frac{\Delta V1 - \Delta V2}{4(It1 - It2)} =: \quad \frac{\Delta Vt}{4 \cdot \Delta It} \qquad (1)$$

In step 20 the first set of measurements ends.

The resistance Ra may be calculated from the resistances Rtg, Rtr and Rrg using Kirchchoff's rules, yielding

$$Ra = \frac{1}{\frac{4}{Rtr} + \frac{1}{Rtg} + \frac{1}{Rrg}} \qquad (2)$$

For a following second set of measurements, line driver 9A of Fig. 2 is deactivated, i.e. set in a high impedance state as explained above. The resulting equivalent circuit for this second configuration of the communication line is represented in a simplified form in Fig. 4. Block 21 in Fig. 4 represents SLIC 9 together with the resistors R1-R4 and capacitors C1 and C2 used for connecting SLIC 9 with tip connector 3 and ring connector 4. Also, in Fig. 4 the connection of integrated circuit 10 is omitted since this remains the same as in Fig. 2. Furthermore, only the resistors Rtg, Rtr and Rrg of interest here are represented.

As can be seen, deactivating line driver 9A practically results in disconnecting tip connector 3.

In the second configuration, a second set of measurements schematically represented in the flow chart of Fig. 5 is performed. Step 22 starts this second set of measurements. In step 23, line driver 9A is deactivated, i.e. set to a high impedance state, to establish the state represented in Fig. 4, and a voltage is applied to ring connector 4, using for example line driver 9B. Next, using integrated circuit 10, the voltages at tip connector 3 versus ground Vtg1 and ring connector 4 versus ground Vrg1 are measured. This is now possible since tip connector 3 is virtually disconnected, in particular by using ground as reference voltage 11 of Fig. 2. In step 25, a second voltage different from the first voltage applied in step 23 is applied to ring connector 4. In step 26, again the voltages at tip connector 3 and ring connector 4 versus ground are measured, these voltages being designated by Vtg2 and Vrg2. In step 18, the differences $\Delta V3 = Vtg1-Vtg2$ and $\Delta V4 = Vrg1-Vrg2$ are calculated. Finally, in step 19, a ratio $kht = \Delta V3 / \Delta V4$ is calculated. These calculations may again be performed by measurement control 10A integrated within integrated circuit 10 or in any other suitable computing facility. In step 20, the second set of measurements is ended.

By again using Kirchhoff's rules, it can be shown that

$$kht = \frac{Rtg}{Rtr + Rtg} \qquad (3)$$

Finally, for a third set of measurements using a third configuration, the second line driver 9B is set to the high impedance state, resulting in the schematic equivalent circuit of Fig. 6. Compared to Fig. 4, the situation here is reversed, i.e. the tip line is connected and the ring line is practically disconnected.

The third set of measurements represented in the flow chart of Fig. 7 basically corresponds to the second set of measurements of Fig. 5. In step 30, the third set of measurements is started. In step 31, a first voltage is applied to the tip connector 3 by the first line driver 9A with the second line driver 9B deactivated. In step 32, integrated circuit 10 is, like in step 24 of Fig. 5, used to measure a voltage Vtg3 between the tip connector 3 and ground and a voltage Vrg3 between the ring connector 4 and ground.

Next, in step 33, a second voltage is applied to tip connector 3, with the second line driver 9B still being deactivated in its high impedance state. In step 34, the same voltages as in step 32 are measured, designated Vtg4 and Vrg4.

In step 35, ΔV5 = Vtg3-Vtg4 and ΔV6 = Vrg3-Vrg4 are calculated. Finally, in step 36, the ratio khr = ΔV5 / ΔV6 is calculated, and in step 37 the third set of measurements ends. As stated before, the calculations may generally be performed in measurement control 10A.

Using Kirchhoff's rules again, it can be shown that

$$khr = \frac{Rrg}{Rtr + Rrg} \qquad (4)$$

So far, Ra, kht and khr have been determined, leading to the three equations (2), (3) and (4) for the three variables Rrg, Rtr and Rrg. By solving this set of equations, the variables can be determined. To achieve this, in a first step, equations (3) and (4) may be substituted into equation (2), yielding

$$Rrg = \frac{Rtr \times khr}{1 - khr} \qquad (5)$$

and

$$Rtg = \frac{Rtr \times kht}{1 - kht} \qquad (6)$$

Substituting equations (5) and (6) again in equation (2) yields the following result for Rtr:

$$Rtr = 2 \times Ra + \frac{Ra}{khr} + \frac{Ra}{kht} \qquad (7)$$

After Rtr has been calculated according to equation (7), Rrg and Rtg may be calculated using this result and equations (5) and (6), respectively. The results thus calculated will represent the real line condition with a very good accuracy.

There may be cases where Rtr has a high value as compared to the resistances Rtg and Rrg which represent leakages between the tip line and the ring line and ground, respectively. In an even more extreme case, there may be no connection between tip line and ring line, resulting in Rtr being infinite. In this case, as can be seen from equations (5) and (6), the method represented above for calculating Rrg and Rtg is not suitable. In the following, an easy way for determining Rtg and Rrg for this case is presented.

In Fig. 8, a flow chart for a set of measurements usable to determine Rrg in case Rtr is high or infinite is shown. In step 52, the measurements for calculating Rrg are started. In step 53, a voltage is applied to ring connector 4, e.g. by line driver 9B, while line driver 9A is set to its high impedance state, i.e. the state shown schematically in Fig. 4. In step 54, the voltage between ring connector 4 and ground Vrg5 is measured by integrated circuit 10, and the current It3 between tip connector 3 and ring connector 4 is measured by SLIC 9. Although line driver 9A is set to its high impedance state, some current will flow due to leakage via resistances Rrg and Rtg to ground.

In step 55, a second voltage different from the voltage applied in step 53 is applied to ring connector 4 by line driver 9B, line driver 9A still being in its high impedance state. In step 56, the same voltage and current as in step 54 are measured as described above, designated by Vrg6 and It4. In step 57, ΔV7 = Vrg5-Vrg6 and ΔIt3 = It3-It4 are calculated. Finally, in step 58, Rht = ΔV7 / (2 x ΔIt3) is calculated, e.g. by measurement control 10A. In step 59, the measurement and calculation procedure ends.

Next, it will be shown that in the above-mentioned case according to which Rtr is high or infinite, Rht corresponds to Rrg. It can be shown that

$$Rht = \frac{1}{\frac{1}{Rrg} + \frac{1}{Rtr + Rtg}} \qquad (8)$$

For Rtr having a large value, equation (8) can be simplified to

$$Rht \approx \frac{1}{\frac{1}{Rrg}} = Rrg \qquad (9)$$

i.e. Rht corresponds to Rrg in this case.

In a similar manner, Rtg may be calculated performing the same steps as shown in Fig. 8 for Rrg with the roles of the tip connector 3 and the ring connector 4 and the respective first and second line driver being reversed. This then leads to the determination of Rhr as follows:

$$Rhr = \frac{1}{\frac{1}{Rtg} + \frac{1}{Rtr + Rrg}} \approx Rtg \qquad (10)$$

Consequently, it has been shown that Rrg and Rtg can be determined even in case Rtr is high or infinite.

Of course, the measurements and calculations described above only serve as an illustrative example. Using Kirchhoff's rules, many other possible sets of measurements may be carried out in order to determine the resistance values Rrg, Rtr and Rtg. For example, other combinations of voltages applied to tip connector 3 and/or ring connector 4 of Fig. 1 and 2 may be used, together with respective voltage or current measurements, to obtain a different set of equations for calculating Rtg, Rrg and Rtr. Depending on the choice of measurements, these equations may however be more complicated to solve than the set of equations obtained with the measurements as described above.

In the following, the measurement and evaluation of the capacitive properties of the communication line, i.e. of the capacitances Ctg, Crg and Ctr will be explained with reference to Figs. 9-15.

In general, the method described herein takes advantage of the fact that capacitances can be measured by applying a time-varying voltage and measuring the current flowing into or from the capacitance. The basic formula on which the capacitance measurement technique used herein is based is

$$I = C \times dU / dt \,. \qquad (11)$$

As can be seen from equation (11), the capacitance C can be measured as the ratio of the current flowing into or from a capacitor and the slope of a voltage ramp applied to the capacitor. In case of a voltage ramp having a constant slope dU/dt, the resulting current is constant. In the apparatus as shown in Fig. 2, voltage ramps can be applied to the communication line using the voltage ramp generator 11. The voltage ramp generator 11 is configured in such a manner that the slope of the voltage ramp, the start voltage of the voltage ramp and the end voltage of the voltage ramp can be freely programmed. Further, current-sensing means of the SLIC 9 or the measurement control 10A of the integrated circuit 10 is configured in such a manner, that the current flowing via at least one of the tip line 6 and the ring line 7 can be integrated over a predetermined period of time substantially corresponding to the duration of the voltage ramp. The integration allows for a more accurate measurement of the current.

Fig. 9 shows a first configuration for performing a first set of measurements for evaluating the capacitances Ctg, Crg and Ctr. In general, the resistive properties of the communication line will have an effect on the measurements that cannot be neglected. The technique described below takes into account this fact and shows how to cancel out the currents from the measurements which are caused by the resistive properties of the equivalent circuit. However, since the resistive properties, i.e. the resistances Rtg, Rrg and Rtr, are included in the network model of the communication line, the values of the resistors are preferably determined as described above and used when calculating the values of the capacitances Ctg, Crg and Ctr from the measured parameters.

The basic idea to cancel out the effect of the resistances Rtg, Rrg and Rtr is to create voltage ramps in two opposite directions, integrate the current measured during the voltage ramps both times over the same period of time, and then subtract the integrated measured currents. The integral of the currents caused by the resistive properties of the communication line is the same in each case and will cancel out in the subtraction. The integral of the currents due to the capacitive properties of the communication line is equal and opposite both times and will sum up to twice the real value. The latter can be easily taken into account in the evaluation, essentially by performing a division by two.

With respect to the integration it is important that the integration windows have the same width in both cases. Further, the integration windows should be arranged symmetrically, i.e. the integration windows are positioned in such a manner that a start voltage of the second integration window exactly corresponds to an end voltage of the first integration window and vice versa.

To calculate the values of three independent capacitances, i.e. the capacitances Ctg, Crg and Ctr, three linearly independent equations are needed. Thus, three different parameters have to be measured which is accomplished by performing the measurements using three different configurations of the communication line. These three different configurations are analogous to the configurations used in the resistance measurements as described above.

In the first configuration, which is shown in Fig. 9, both line drivers 9A and 9B are in the low-impedance state. A first voltage ramp is applied to both the tip line 6 and the ring line 7 with half of the steepness against ground on each of the tip line 6 and the ring line 7. The first voltage ramp is followed by a second voltage ramp which is inverted with respect to the first voltage ramp. This means, that the second voltage ramp has a slope with the same magnitude as the first voltage ramp but with opposite sign, that the start voltage of the second voltage ramp corresponds to an end voltage of the first voltage ramp, and that an end voltage of the second voltage ramp corresponds to a start voltage of the first voltage ramp. During each of the voltage ramps, a current flowing from tip connector 3 to ring connector 4 is measured.

The voltage ramps and the measured currents as a function of time t are illustrated in Fig. 10. As can be seen, the voltage signal applied to the communication line has a substantially trapezoidal shape. The trapezoidal voltage signal consists of a first voltage ramp and a second voltage ramp. The voltage ramps are symmetrical with respect to a center point there between. The slopes of the voltage ramps have the same magnitude but opposite signs, the start voltage of the second voltage ramp corresponds to the end voltage of the first voltage ramp and the end voltage of the second voltage ramp corresponds to the start voltage of the first voltage ramp. The current due to the capacitive properties of the communication line is illustrated in the lower part of Fig. 10. As can be seen, an essentially constant current flows during each of the first voltage ramp and the second voltage ramp, the direction of the current depending on the direction of the voltage ramp.

Fig. 11 shows a flowchart of a first set of measurements for determining the capacitive properties of the communication line. During this first set of measurements, both line drivers 9A and 9B are active, i.e. in the low-impedance state. The line drivers 9A and 9B are used to apply a sequence of voltage ramps to tip line 6 and ring line 7, as illustrated in Fig. 10.

In step 60 of Fig. 11, the set of measurements is started. In step 61, a transversal voltage is applied to the communication line. The transversal voltage constitutes a start voltage of a first voltage ramp.

Next, in step 62, the first voltage ramp having a slope SL1 is applied to the communication line, starting from the start voltage, and finishing at an end voltage of the first voltage ramp. In step 63, the current flowing from the tip connector 3 to the ring connector 4 during the first voltage ramp is measured and integrated, resulting in an integrated measured current, designated by It5a.

Next, in step 64, a second voltage ramp having a slope -SL1 is started from the end voltage of the first voltage ramp, finishing at the start voltage of the first voltage ramp. In step 65, the current measured during the second voltage ramp is integrated, resulting in an integrated measured current It5b.

Then, in step 66, a current It5 is calculated according to

$$It5 = (It5a - It5b)/2 \; . \qquad (12)$$

In step 67, the first set of measurements for determining the capacitive properties ends.

The current It5 can be expressed in terms of the electrical properties of the communication line by the following term:

$$It5 = Ctr \times SL1 + Ctg\left(\frac{SL1}{4}\right) + Crg\left(\frac{SL1}{4}\right). \qquad (13)$$

A second configuration for a second set of measurements for determining the capacitive properties of the communication line is illustrated in Fig. 12. Like in the configuration illustrated in Fig. 4 line driver 9A is deactivated, i.e. switched into the high-impedance state, which practically results in disconnecting tip connector 3.

The second set of measurements performed in this configuration is schematically represented in the flowchart of Fig. 13. In step 70, the second set of measurements starts. In step 71, line driver 9A is deactivated, i.e. switched into the high-impedance state, to establish the configuration represented in Fig. 12, and a voltage is applied to ring connector 4 via line driver 9B. The voltage applied to ring connector 4 corresponds to the start voltage of a first voltage ramp to be applied to the communication line.

In step 72, a first voltage ramp having a slope SL2 is applied to ring connector 4, starting at the start voltage of the first voltage ramp and finishing at an end voltage of the first voltage ramp.

As compared to the configuration of the first set of measurements for determining the capacitive properties, the voltage ramp is not applied with respect to the tip line 6, but with respect to ground 8. In step 73, the current flowing into or from ring connector 4 is measured and integrated so as to result in an integrated measured current It6a.

Next, in step 74, a second voltage ramp having a slope -SL2 is applied to ring connector 4, starting at the end voltage of the first voltage ramp and finishing at the start voltage of the first voltage ramp. In step 75, the current flowing into or from ring connector 4 during the second voltage ramp is measured and integrated so as to obtain an integrated measured current It6b.

In step 76, a current It6 is calculated according to

$$It6 = (It6a - It6b)/2. \qquad (14)$$

The second set of measurements for determining the capacitive properties ends at step 77.

The current measured in the second configuration as shown in Fig. 12 can be expressed in terms of the electrical properties of the communication line by the following term:

$$It6 = Ctr\left(\frac{SL2 \times k2}{2}\right) + Crg\left(\frac{SL2}{2}\right) + Ctg\left(\frac{SL2 \times j2}{2}\right). \qquad (15)$$

In equation (15) the parameters j2 and k2 are defined as follows:

$$j2 = \left(\frac{Rtg}{Rtr + Rtg}\right)^2 \text{ and} \qquad (16)$$

$$k2 = \left(\frac{Rtr}{Rtr + Rtg}\right)^2. \qquad (17)$$

A third configuration of the communication line used for a third set of measurements for determining the capacitive properties of the communication line is represented in Fig. 14. As compared to the second configuration shown in Fig. 12, the first line driver 9A is activated and the second line driver 9B is deactivated, i.e. switched into the high-impedance state. Therefore, tip line 6 is practically disconnected.

The third set of measurements for determining the capacitive properties of the communication line is schematically represented in the flowchart of Fig. 15. The third set of measurements basically corresponds to the second set of measurements as described with reference to Fig. 13. In step 80, the third set of measurements starts. In step 81, the first line driver 9A is activated and the second line driver 9B is deactivated, so as to achieve the configuration as represented in Fig. 14. A voltage corresponding to a start voltage of a first voltage ramp is applied to ring connector 3. Also in this configuration, the applied voltages are defined with respect to ground.

In step 82, a first voltage ramp having a slope SL3 is applied to tip connector 3, starting at the start voltage and finishing at an end voltage. In step 83, the current flowing into or from tip connector 3 during the first voltage ramp is measured and integrated, resulting in an integrated measured current It7a.

In step 84, a second voltage ramp having a slope -SL3 is applied to tip connector 3, starting at the end voltage of the first voltage ramp and finishing at the start voltage of the first voltage ramp. In step 85, the current flowing into or from tip connector 3 during the second voltage ramp is measured and integrated, resulting in an integrated measured current It7b.

Then, in step 86, a current It7 is calculated according to

$$It7 = (It7a - It7b)/2\ . \tag{18}$$

At step 87, the third set of measurements for determining the capacitive properties of the communication line ends.

The current It7 obtained in the third set of measurements can be expressed in terms of the electric properties of the communication line by the following term:

$$It7 = Ctr\left(\frac{SL3 \times k3}{2}\right) + Ctg\left(\frac{SL3 \times j3}{2}\right) + Ctg\left(\frac{SL3}{2}\right)\ . \tag{19}$$

In equation (19), the terms j3 and k3 are defined as follows:

$$j3 = \left(\frac{Rrg}{Rtr + Rrg}\right)^2 \text{ and} \tag{21}$$

$$k3 = \left(\frac{Rtr}{Rtr + Rrg}\right)^2 . \tag{22}$$

In the measurements described with reference to Figs. 11, 13 and 15, the timing of the measurement steps it suitably controlled so as to avoid transient effects or alteration of the measurement results due to incomplete charging of the capacitances. In particular, before starting a voltage ramp and measuring the current, an adequate delay is included. The delay helps to ensure that the capacitances have fully charged after applying the start voltage of the voltage ramp. The calculations may be carried out by the measurement control 10A.

By performing the three sets of measurements for determining the capacitive properties of the communication line, the parameters It5, It6 and It7 have been determined.

These parameters are linked to the electrical properties of the communication line by three linearly independent equations, namely equations (13), (15) and (19). By solving this set of equations, the capacitances Ctg, Crg and Ctr can be determined. Solving the linear equation system yield the following result:

$$Ctr = \frac{2}{SL1 \times SL2 \times SL3 \times (j3 \times k2 + k3 \times j2 - 4 \times j2 \times j3 - k2 - k3 + 4)} \times ( j3 \times SL1 \times SL3 \times It6 - SL1 \times SL3 \times It6 + 2 \times SL2 \times SL3 \times It5 - SL1 \times SL2 \times It7 + j2 \times SL1 \times SL2 \times It7 - 2 \times j2 \times j3 \times SL2 \times SL3 \times It5 ), \quad (23)$$

$$Crg = \frac{2}{SL1 \times SL2 \times SL3 \times (j3 \times k2 + k3 \times j2 - 4 \times j2 \times j3 - k2 - k3 + 4)} \times ( 2 \times k2 \times SL2 \times SL3 \times It5 - 2 \times j2 \times k3 \times SL2 \times SL3 \times It5 - 4 \times SL1 \times SL3 \times It6 + 4 \times j2 \times SL1 \times SL2 \times It7 + k3 \times SL1 \times SL3 \times It6 - k2 \times SL1 \times SL2 \times It7 ) \quad (24)$$

and

$$Ctg = \frac{2}{SL1 \times SL2 \times SL3 \times (j3 \times k2 + k3 \times j2 - 4 \times j2 \times j3 - k2 - k3 + 4)} \times ( k3 \times SL1 \times SL3 \times It6 - 4 \times j3 \times SL1 \times SL3 \times It6 - k2 \times SL1 \times SL2 \times It7 + 2 \times j3 \times k2 \times SL2 \times SL3 \times It5 - 2 \times k3 \times SL2 \times SL3 \times It5 + 4 \times SL1 \times SL2 \times It7 ) \quad (25)$$

As can be seen, using the results previously obtained for the resistances Rtg, Rrg and Rtr, the capacitances Ctg, Crg and Ctr can be calculated. Of course, it would also be possible to directly calculate the capacitances using the results obtained in the sets of measurements as explained with reference to Figs. 3-7.

Further, it will be appreciated that if a smaller number or only one of the electrical properties of the communication line is of interest, the number of measurements may be reduced accordingly. Generally, for each of the resistances and each of the capacitances one set of measurements will be required. Moreover, the sets of measurement using a similar configuration, could be combined. In addition, the techniques described above could also be used to estimate the resistance Re and the capacitance Ce of the subscriber equipment 5 connected to the communication line.

## Claims

1. A method of measuring at least one capacitive property (Ctg, Crg, Ctr) of a communication line, wherein the communication line comprises a first line (6) and a second line (7),
**characterized by**
applying at least a first voltage ramp to at least one of the first line (6) and the second line (7) and measuring at least a first current flowing via the at least one of the first line (6) and the second line (7) during the first voltage ramp, calculating the capacitive property (Ctg, Crg, Ctr) on the basis of the first measured current.

2. The method according to claim 1,
**characterized by**
applying a second voltage ramp to the at least one of the first line (6) and the second line (7) and measuring a second current flowing via the at least one of the first line (6) and the second line (7) during the second voltage ramp and calculating the capacitive property (Ctg, Crg, Ctr) on the basis of the first measured current and the second measured current,
wherein the second voltage ramp is inverted with respect to the first voltage ramp.

3. The method according to claim 2,
**characterized in that**
the first voltage ramp and the second voltage ramp have slopes of equal magnitude and of opposite sign,
wherein a start voltage of the second voltage ramp corresponds to an end voltage of the first voltage ramp, and
wherein an end voltage of the second voltage ramp corresponds to a start voltage ramp of the first voltage ramp.

4. The method according to claim 2 or 3,
**characterized by**
integrating the first measured current and the second measured current.

5. The method according to claim 4,
**characterized by**
subtracting the integrated first measured current and the integrated second measured current.

6. The method according to claim 4 or 5,
**characterized in that**
the integration time of the first measured current and the second measured current substantially corresponds to the duration of the first voltage ramp and the second voltage ramp.

7. The method according to any one of the preceding claims,
**characterized in that**
a plurality of measurements is performed in different configurations of the communication line,
wherein at least the first measured current is determined in each of the different configurations, and
wherein a plurality of capacitive properties (Ctg, Crg, Ctr) is determined on the basis of at least the first measured current of the different configurations.

8. The method according to any one of the preceding claims,
**characterized by**
applying a voltage to at least one of the first line (6) and the second line (7),
measuring a current flowing via the at least one of the first line (6) and the second line (7), and/or
measuring a voltage present at the first line (6) and/or the second line (7),
wherein the step of calculating the at least one capacitive property (Ctg, Crg, Ctr) of the communication line is further performed on the basis of the measured current and/or voltage (s).

9. The method according to claim 8,
**characterized by**
calculating at least one resistive property of the communication line on the basis of the measured current and/or voltage(s).

10. The method according to claim 9,
**characterized in that**
the at least one resistive property (Rtg, Rrg, Rtr) is selected from the group comprising a resistance (Rtg) between the first line (6) and ground (8), a resistance (Rrg) between the second line (7) and ground (8), and a resistance (Rtr) between the first line (6) and the second line (7).

11. The method according to any one of claims 8-10,
**characterized in that**
a plurality of measurements is performed in different configurations of the communication line,
wherein the measured current and/or the measured voltage (s) is determined in each of the different configurations,
wherein the step of calculating the at least one capacitive property (Ctg, Crg, Ctr) is performed additionally on the basis of the measured current and/or the measured voltage(s) of the different configurations.

12. The method according to claim 11,
**characterized by**
calculating a plurality of resistive properties (Rtg, Rrg, Rtr) of the communication line on the basis of the measured current and/or the measured voltage(s) of the different configurations.

**13.** The method according to any one of claims 8-12,
**characterized in that**
the different configurations correspond to switching a first line driver (9A) connected to the first line (6) or a second line driver (9B) connected to the second line (7) into either a high-impedance state or a low-impedance state.

**14.** The method according to claim 13,
**characterized in that**
in a first configuration, the first line driver (9A) and the second line driver (9B) are in the low-impedance state, and a voltage is applied to both the first line (6) and the second line (7),
in a second configuration, the first line driver (9A) is in the low-impedance state, the second line driver (9B) is in the high-impedance state, and a voltage is applied to the first line (6), and
in a third configuration, the first line driver (9A) is in the high-impedance state, the second line driver (9B) is in the low-impedance state, and a voltage is applied to the second line (7).

**15.** The method according to claim 13 or 14,
**characterized in that**
the high-impedance state of the first line driver (9A) or the second line driver (9B) is a state where a leakage current flowing via the first line driver (9A) or second line driver (9B), respectively, is below 150 $\mu$A for voltages applied up to 150 Volt.

**16.** The method according to claim 15,
**characterized in that**
the leakage current is below 30 $\mu$A.

**17.** The method according to any one of claims 13-16,
**characterized in that**
the high-impedance state of the first line driver (9A) or the second line driver (9B) is a state where the impedance of the first line driver (9A) or the second line driver (9B), respectively, is at least one M$\Omega$.

**18.** The method according to any one of the preceding claims, **characterized in that** the communication line is comprised in a POTS-communication system, wherein the first line (6) is a tip line and the second line (7) is a ring line.

**19.** The method according to any one of the preceding claims,
**characterized in that**
the at least one capacitive property (Ctg, Crg, Ctr) is selected from the group comprising a capacitance (Ctg) between the first line (6) and ground (8), a capacitance (Crg) between the second line (7) and ground (8), and a capacitance (Ctr) between the first line (6) and the second line (7).

**20.** An apparatus for measuring at least one capacitive property (Ctg, Crg, Ctr) of a communication line,
wherein the communication line comprises a first line (6) and a second line (7), and
wherein the apparatus comprises a control unit (10A) for controlling the process of measuring the at least one capacitive property (Ctg, Crg, Ctr),
**characterized in that**
the apparatus comprises a voltage ramp generator (11), current measuring means (9) and calculating means (10A), wherein the control unit (10A) is configured in such a manner that it controls the apparatus to apply at least a first voltage ramp generated by the voltage ramp generator (11) to at least one of the first line (6) and the second line (7) and to measure a first current flowing via the at least one of the first line (6) and the second line (7) during the first voltage ramp by means of the current measuring means, and
wherein the calculating means (10A) are configured to calculate the capacitive properties (Ctg, Crg, Ctr) on the basis of at least the first measured current.

**21.** The apparatus according to claim 20,
wherein the apparatus is configured to implement the method according to any one of claims 1-19.

**22.** the apparatus according to claim 20 or 21,
**characterized in that**

the apparatus is implemented by means of components of a POTS chip set.

**23.** A communication linecard (1) to be connected to a communication line, **characterized in that** the linecard (1) comprises the apparatus according to any one of claims 20 to 22.

FIG 1

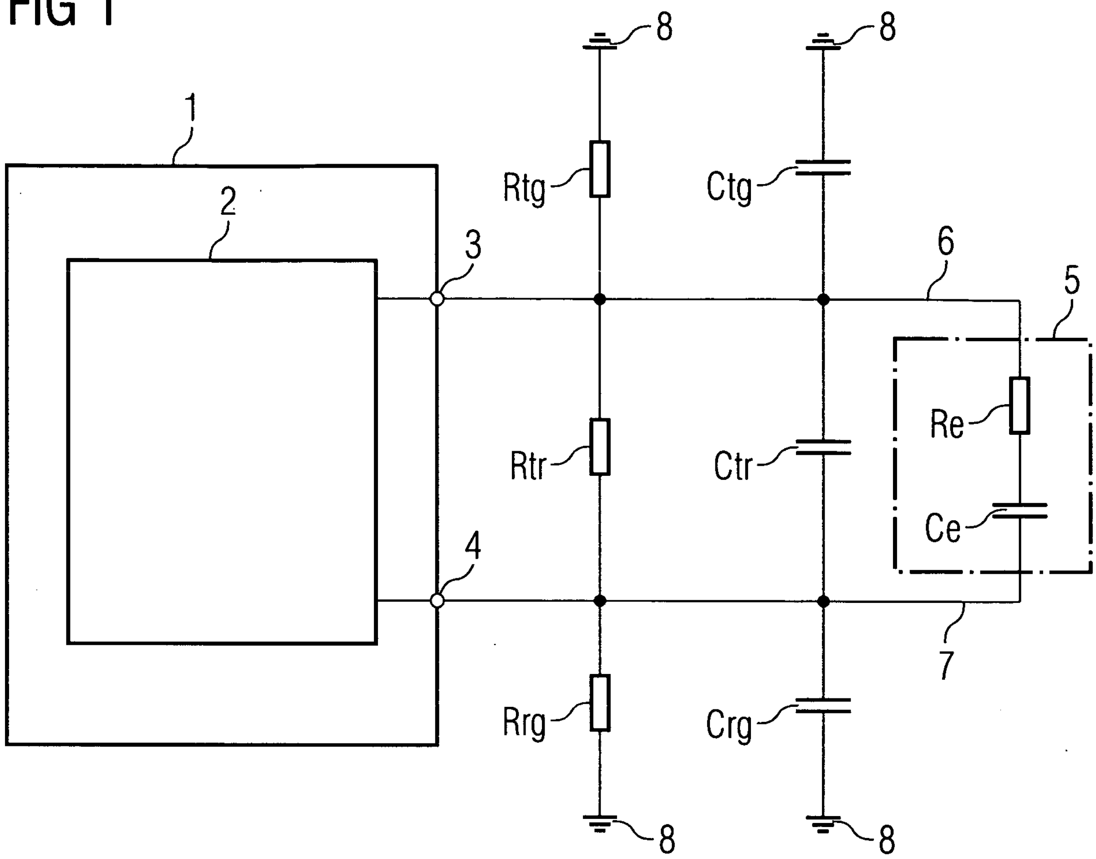
8
8
1
2
3
4
Rtg
Ctg
6
5
Re
Rtr
Ctr
Ce
7
Rrg
Crg
8
8

FIG 2

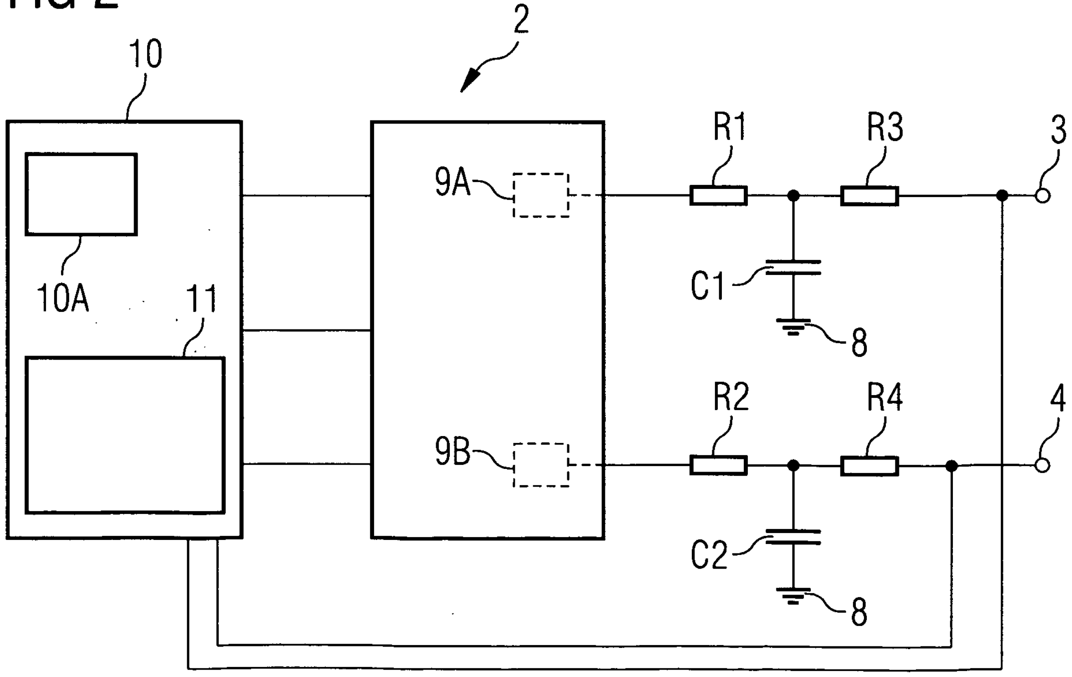
2
10
10A
11
9A
9B
R1
R3
3
C1
8
R2
R4
4
C2
8

FIG 3

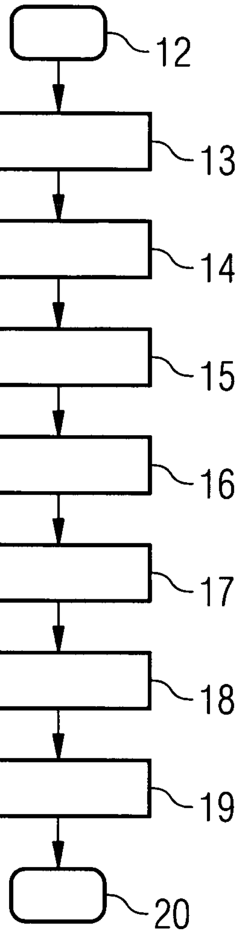


FIG 4

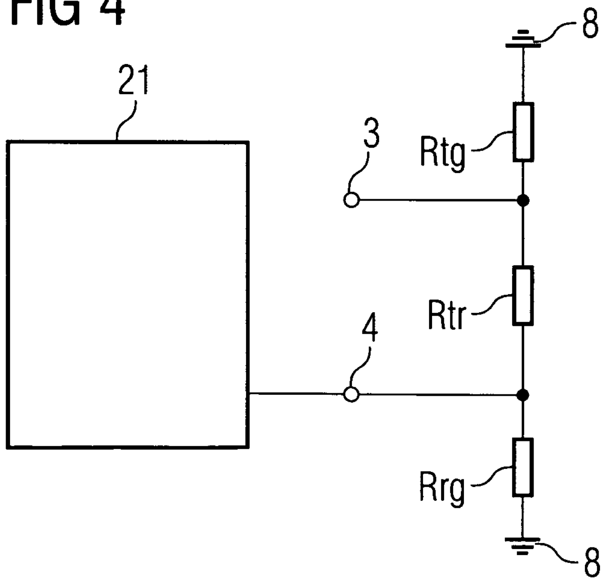

FIG 5

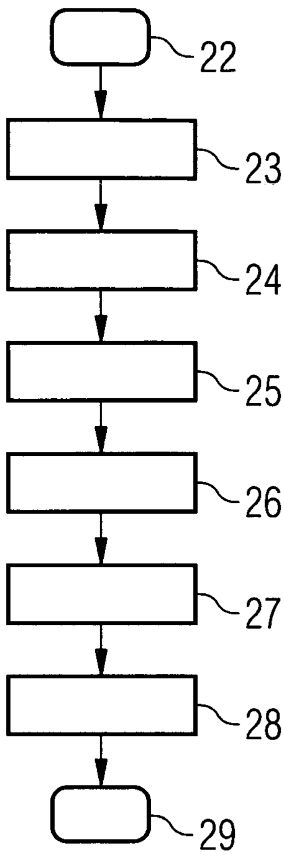


FIG 6

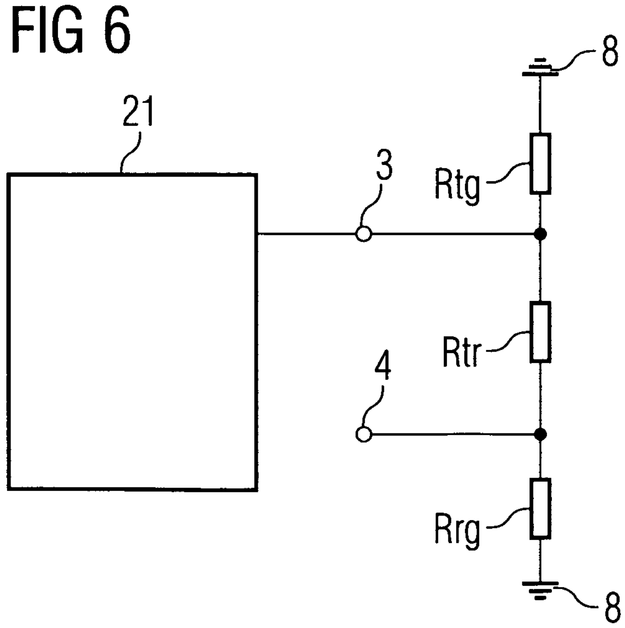

FIG 7

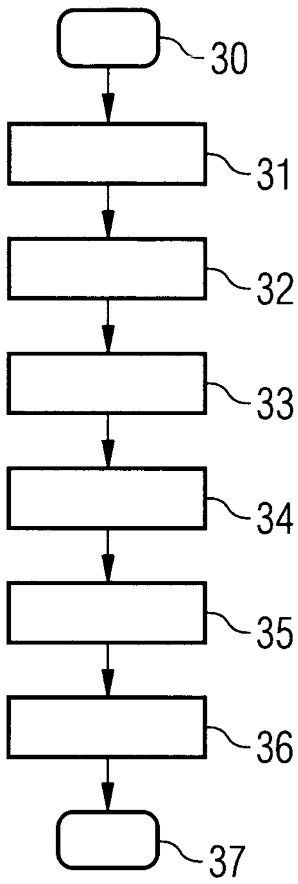


FIG 8

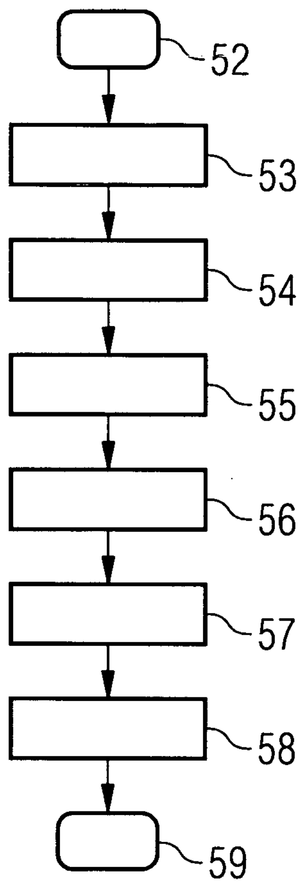

FIG 9

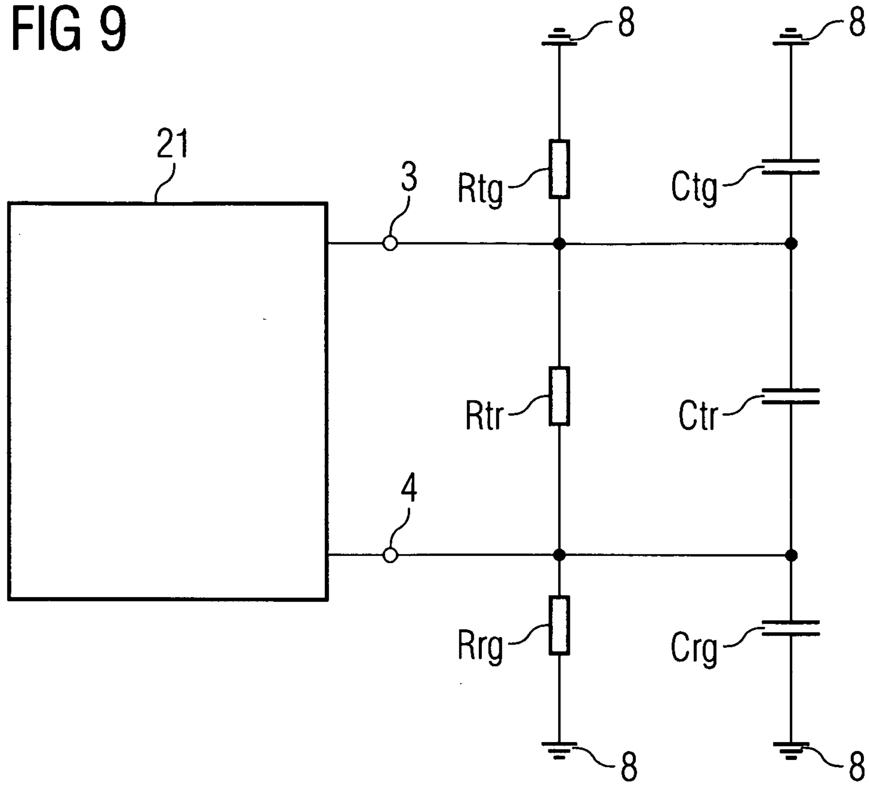


FIG 10

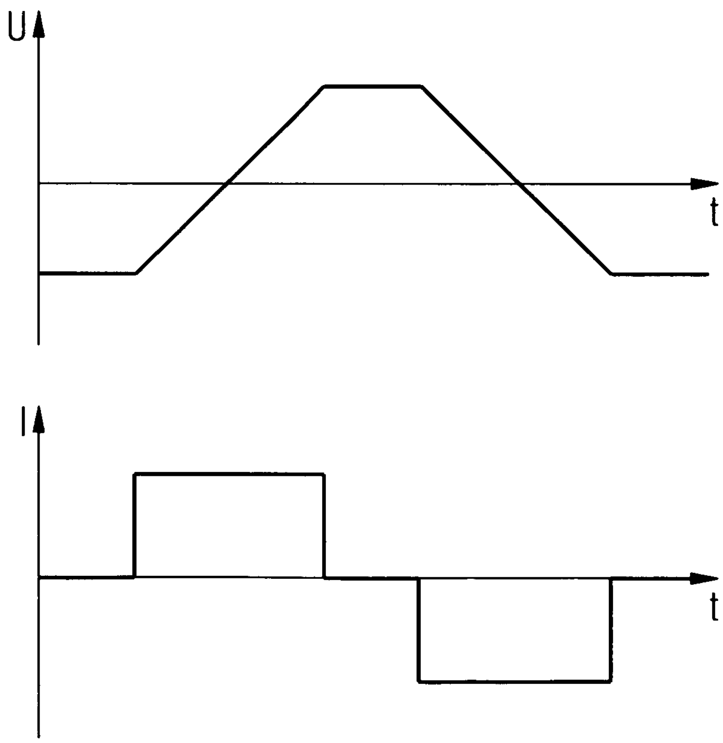

FIG 11

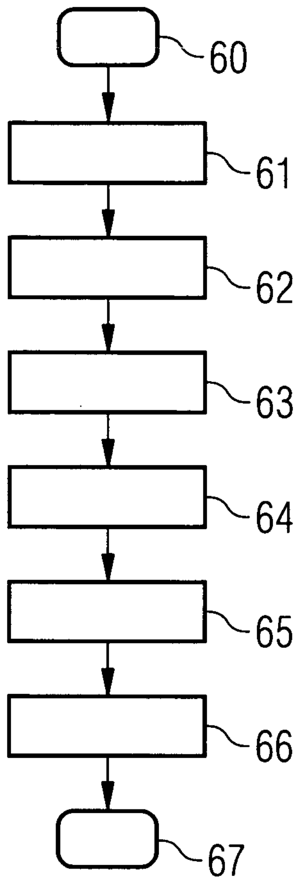


FIG 13

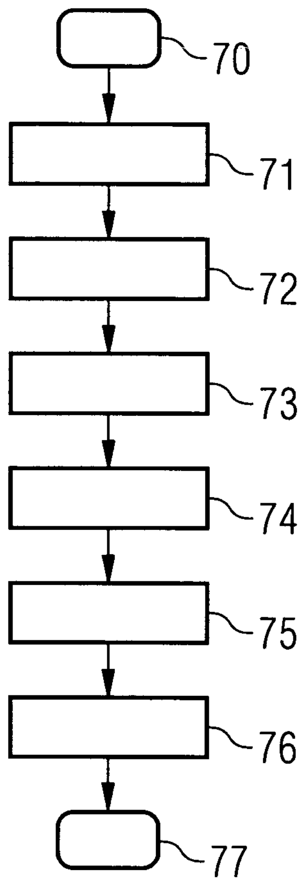

FIG 12

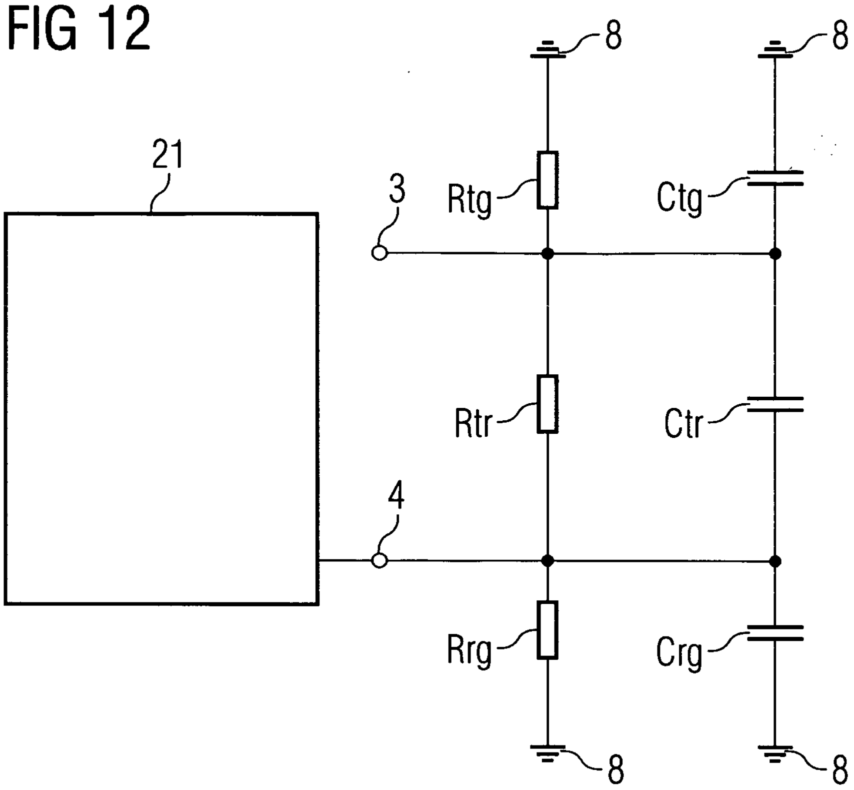
8
8
21
3
Rtg
Ctg
Rtr
Ctr
4
Rrg
Crg
8
8

FIG 14

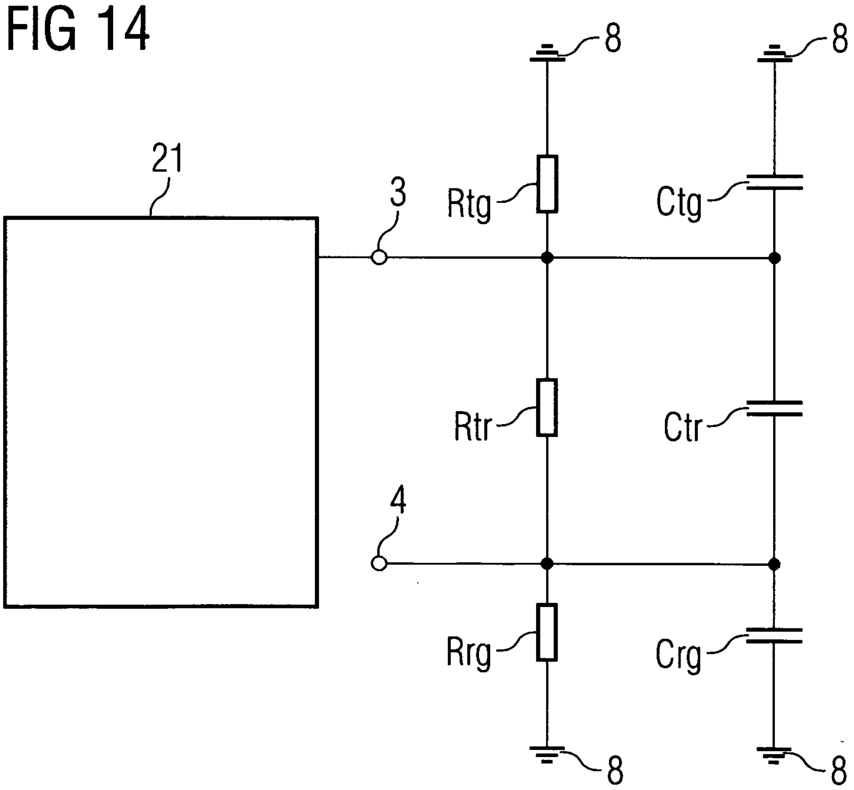
8
8
21
3
Rtg
Ctg
Rtr
Ctr
4
Rrg
Crg
8
8

FIG 15

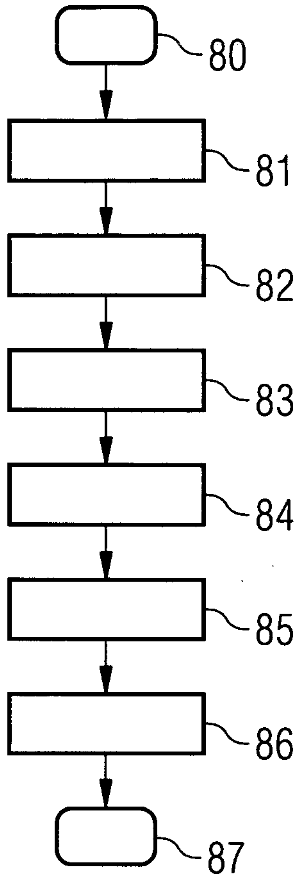

FIG 16

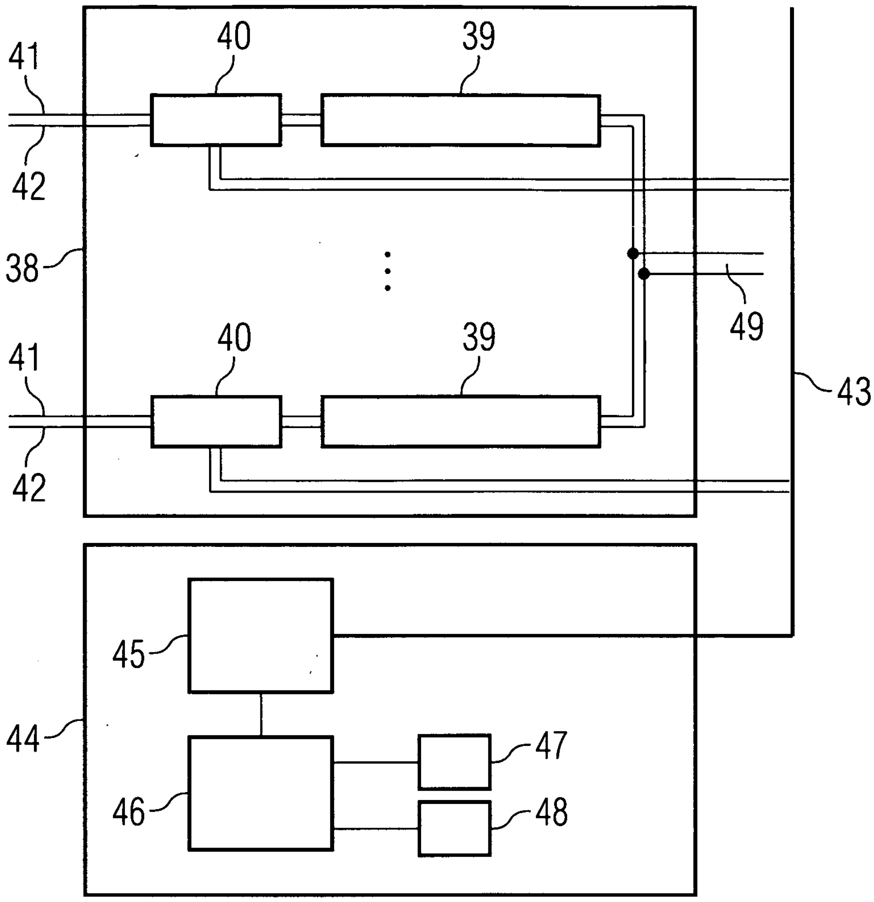


FIG 17

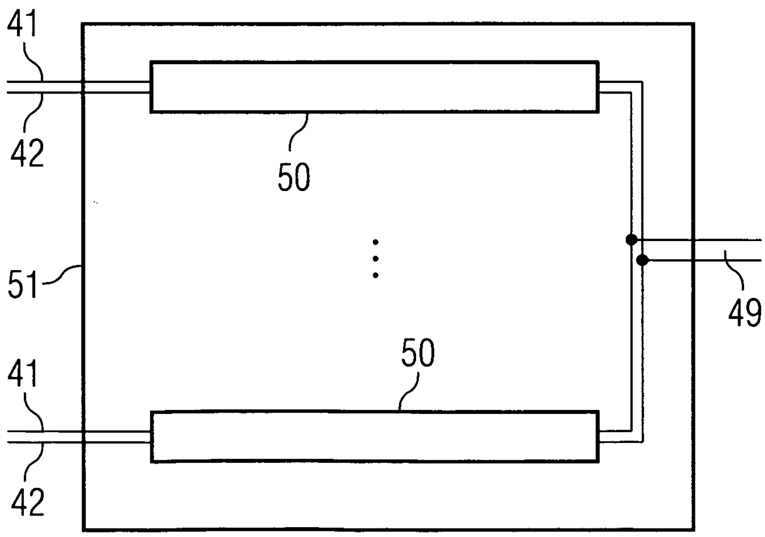

European Patent Office

# EUROPEAN SEARCH REPORT

Application Number
EP 05 01 1706

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br>Y | EP 0 580 947 A (SIEMENS AKTIENGESELLSCHAFT)<br>2 February 1994 (1994-02-02)<br><br>* abstract; figures 1,2 *<br>* page 2, line 27 - page 5, line 23 * | 1-12, 18-23<br><br>13-17 | H04M3/30<br>G01R27/26 |
| Y | EP 0 808 053 A (LUCENT TECHNOLOGIES INC)<br>19 November 1997 (1997-11-19)<br>* abstract; figure 1 *<br>* column 1, line 5 - column 2, line 8 *<br>* column 5, line 21 - column 6, line 34 * | 13-17 | |
| X | US 4 634 964 A (CHATTLER ET AL)<br>6 January 1987 (1987-01-06)<br>* abstract; figures 1,2 *<br>* column 2, line 61 - column 6, line 15 *<br>* column 7, line 10 - column 9, line 8 * | 1-12, 18-21 | |
| A | US 5 625 667 A (VOGT, III ET AL)<br>29 April 1997 (1997-04-29)<br>* abstract; figures 1,5 * | 1-23 | |

TECHNICAL FIELDS SEARCHED (IPC)

G01R
H04M

The present search report has been drawn up for all claims

1

| Place of search | Date of completion of the search | Examiner |
|---|---|---|
| Berlin | 21 November 2005 | Ernst, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 05 01 1706

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2005

| Patent document cited in search report | Publication date | Patent family member(s) | Publication date |
|---|---|---|---|
| EP 0580947 A | 02-02-1994 | AT 166724 T | 15-06-1998 |
| | | DK 580947 T3 | 01-03-1999 |
| | | ES 2116365 T3 | 16-07-1998 |
| EP 0808053 A | 19-11-1997 | CA 2202311 A1 | 10-11-1997 |
| | | JP 10065804 A | 06-03-1998 |
| | | US 5881129 A | 09-03-1999 |
| US 4634964 A | 06-01-1987 | NONE | |
| US 5625667 A | 29-04-1997 | CA 2164620 A1 | 30-03-1995 |
| | | WO 9508893 A1 | 30-03-1995 |
| | | DE 69419165 D1 | 22-07-1999 |
| | | DE 69419165 T2 | 14-10-1999 |
| | | EP 0721722 A1 | 17-07-1996 |
| | | JP 9506215 T | 17-06-1997 |
| | | JP 3294614 B2 | 24-06-2002 |
| | | US 5444759 A | 22-08-1995 |

EPO FORM P0459

For more details about this annex : see Official Journal of the European Patent Office, No. 12/82